Europäisches Patentamt

European Patent Office

Office européen des brevets

(19)

(11) **EP 0 947 843 A2**

(12) **EUROPÄISCHE PATENTANMELDUNG**

(43) Veröffentlichungstag:
06.10.1999 Patentblatt 1999/40

(51) Int. Cl.⁶: **G01R 15/14**

(21) Anmeldenummer: 99105747.2

(22) Anmeldetag: 22.03.1999

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: 28.03.1998 DE 19813890

(71) Anmelder: **ABB Research Ltd.**
**8050 Zürich (CH)**

(72) Erfinder:
**Disselnkötter, Rolf, Dr.rer.nat.**
**69256 Mauer (DE)**

(74) Vertreter: **Miller, Toivo et al**
**ABB Patent GmbH**
**Postfach 10 03 51**
**68128 Mannheim (DE)**

(54) **Verfahren zur Strommessung**

(57) Die Erfindung bezieht sich auf ein Verfahren zur potentialfreien Strommessung mit Störfeldunterdrückung. Es ist geeignet zur Gleich- oder Wechselstrommessung im Nieder-, Mittel- oder Hochspannungsbereich. Zur Ermittlung des in einem Leiter (L) fließenden Stromes wird ein stromproportionales Ausgangssignal ($U^{out}$) eines Sensor-Arrays (Ay) gebildet, wobei das Array (Ay) durch eine Anzahl n von linearen uniaxialen Magnetfeldsensoren (S1....Sn) gebildet wird, die an festen Positionen ($x_l$, $y_l$, $z_l$) in der Nähe des Leiters (L) angeordnet werden und deren sensitive Achsen ($A_S$) parallel zueinander ausgerichtet werden. Das Ausgangssignal ($U^{out}$) wird durch Multiplikation der Einzelsensor-Ausgangssignale mit individuellen Koeffizienten ($b_l$) und Summierung dieser Produkte ermittelt.

Fig. 6

**Beschreibung**

Die Erfindung bezieht sich auf ein Verfahren zur potentialfreien Strommessung mit Störfeldunterdrückung zur Erhöhung der Genauigkeit. Es ist geeignet zur Gleich- oder Wechselstrommessung im Nieder-, Mittel- oder Hochspannungsbereich.

Bekannte Verfahren und Anordnungen zur Strommessung arbeiten oftmals mit einem Magnetkern, der den Leiter umschließt und das ihn umgebende Magnetfeld integriert und homogenisiert, und so einen Induktionswert B bereitstellt, der ein Maß für den umschlossenen Strom darstellt und von externen Strömen und Magnetfeldern weitgehend unbeeinflußt ist. Aus W. Heidenreich, Aufbautechniken für Halbleiter-Magnetfeldsensoren, Technisches Messen 56 (1989) 11, Seite 436 ist es bekannt, den Induktionswert direkt über ein in einem Kern-Luftspalt befindliches Sensorelement zu bestimmen.

Gemäß E. So, D.A. Bennett, A low-current multistage clamp-on current transformer..., IEEE Trans. Instr. Meas. 46 (1997) 2, Seite 454 kann der Induktionswert auch über seine zeitliche Veränderung, also wie im herkömmlichen Stromwandler durch Induktion einer Spannung in einer auf dem Kern befindlichen Drahtwicklung ausgewertet und zur Kontrolle des Ausgangssignals verwendet werden.

Dieses Meßprinzip kann auch so abgewandelt werden, daß der Magnetkern als geschlossener magnetischer Schirm ausgebildet ist, der den Stromleiter und einen Magnetfeldsensor umschließt, wie aus M. Imamura, et al., Analysis of magnetic fields..., contribution CD-09, digests of the 1995 Intermag Conference hervorgeht. Dadurch wird ebenfalls erreicht, daß das Sensorsignal weitgehend unbeeinflußt von externen Magnetfeldern bleibt.

Andere Prinzipien nutzen verteilte (kontinuierliche) Sensoren ohne metallischen Magnetkern, die den Stromleiter umgeben und das Feldintegral nachbilden. Beispiele hierfür sind die Rogowski-Spule (vergl. W.F. Ray, R.M. Davis, Wide Band Rogowski Current Transducers, Part I, EPE Journal, Vol 3 No. 1, March 1993) und Sensoren, die auf dem Faraday-Effekt beruhen, und die als optische Faser oder massiver Glasblock ausgebildet sein können (vergl. R. Stierlin, Faseroptische Sensoren, Teil 2, Bulletin SEV/VSE 82 (1991) 1, Seite 21).

Ein weiterer Ansatz zur Verringerung des relativen Einflusses ("Übersprechen") von Fremdfeldern auf das Ausgangssignal besteht darin, eine Anordnung ("Array") von mehreren Elementarsensoren zu verwenden. Diese werden zumeist längs eines geschlossenen, den Leiter umgebenden, in einigen Fällen zirkularen, Pfades angeordnet, während ihre Ausgangssignale z. B. durch elektrische Reihenschaltung oder einen Addierverstärker summiert werden. Auf diese Weise wird wieder das Feldintegral approximiert, und damit das Übersprechen verringert (vergl. J.T. Scoville, P.I. Petersen, A low-cost Hall probe current transducer, Rev. Sci. Instrum. 62, 3 (1991), Seite 755 und L. Koller, P. Szalma, Neuartige Rogowski-Spule..., Electrical Engneering 80 (1997), Seite 115).

In einem anderen Ansatz (vergl. Kreinovich, et al., A new method of measuring strong currents..., Computers Elect. Engng., Vol. 23, No. 2 (1997), Seite 121) wird von einer parallelen Anordnung eines Leiters und eines Störleiters ausgegangen. Für eine spezielle Anordnung von vier Elementar-Magnetfeldsensoren, deren sensitive Achsen in verschiedene Richtungen orientiert sind, wird das Magnetfeld am Ort der Sensoren in Abhängigkeit der unbekannten Größen (zwei Leiterströme und die zwei Ortskoordinaten des Störleiters) berechnet. Hieraus ergeben sich vier Bestimmungsgleichungen, aus denen die vier Unbekannten (insbesondere der zu messende Strom) berechnet werden können. Weiter bekannt sind gradiometrische Anordnungen zweier Magnetfeld-Sensoren, die nur den durch einen Leiterstrom erzeugten Gradienten der Feldverteilung auswerten, und die durch entferntere Feldquellen hervorgerufenen, räumlich konstanten Felder somit unterdrücken (vergl. Y. Kashiwagi, et al., 300 A current sensor..., IEEE Trans. Magn., Vol 26, No. 5, September 1990).

Die bekannten Verfahren zur genauen und potentialfreien Strommessung mit Störfeldunterdrückung haben folgende Nachteile:

- Sensoren mit massivem Magnetkern oder mit magnetostatischer Abschirmung sind (besonders bei höheren Strömen oder Betriebsspannungen) voluminös und teuer.
- Genaue Rogowskispulen erfordern eine hohe Präzision der Bewicklung; sie können daher nur mit verhältnismäßig großem Aufwand (und Kosten) hergestellt werden.
- Optische (Faraday-) Sensoren sind noch sehr teuer, und aufgrund dessen bisher den Hochspannungsanwendungen vorbehalten.
- Bisher bekannte Ansätze mit Mehrfach-Sensoren (Sensor-Arrays) gehen entweder von einer bekannten Anordnung von Leiter und Störleiter aus (was oft nicht den Gegebenheiten entspricht), oder sie benötigen eine große Anzahl von Sensoren, um das Feldintegral mit ausreichender Genauigkeit zu approximieren.
- Gradiometrische Anordnungen unterdrücken nur den räumlich konstanten Störfeldanteil und erreichen daher nur eine unvollkommene Reduktion des Einflusses naher Störleiter.

Der Erfindung liegt daher die Aufgabe zugrunde, ein Verfahren zur Strommessung anzugeben, das die vorgenannten Nachteile vermeidet.

Diese Aufgabe wird durch ein Verfahren zur Strommessung mit den im Anspruch 1 angegebenen Merkmalen gelöst. Vorteilhafte Ausgestaltungen sind in weiteren Ansprüchen angegeben.

Das Verfahren geht zunächst von einer beliebigen Anzahl n von linearen, uniaxialen Magnetfeldsensoren aus, die sich in beliebigen festen Positionen $(x_l, y_l, z_l)$ in der Nähe des Leiters befinden, dessen Strom gemessen werden soll. Ihre sensitiven Achsen sollen alle parallel ausgerichtet sein. $H(x,y,z)$ sei die räumliche Verteilung der zur sensitiven Achse parallelen Vektorkomponente des magnetischen Feldes, die sich aus dem durch den zu messenden Strom erzeugten Nutzanteil $H_l(x,y,z)$, sowie zusätzlichen äußeren Störfeldern zusammensetzt. Diese können durch benachbarte Leiter oder andere Magnetfeldquellen hervorgerufen werden.

Die Ausgangssignale der n Sensoren werden durch geeignete Maßnahmen so miteinander verknüpft, daß für das auf einen Referenzwert bezogene, normierte Ausgangssignal des gesamten Systems (Stromsensor) die folgende Beziehung gilt:

$$U^{out} = \sum_{l=1}^{n} b_l H(x_l, y_l, z_l) \tag{1}$$

Ein Ziel der Erfindung besteht darin, die Werte der Koeffizienten $b_l$ so zu bestimmen, daß der Einfluß beliebiger externer Felder auf das Ausgangssignal des Stromsensors minimiert wird.

Dazu wird zunächst davon ausgegangen, daß das Feld $H(x,y,z)$ um einen Referenzpunkt in der Nähe der Sensoren und des Nutzstromleiters herum in eine Potenzreihe der folgenden Form entwickelt werden kann:

$$H(x,y,z) = \sum_{i=0}^{\infty}\sum_{j=0}^{\infty}\sum_{k=0}^{\infty} H_{i,j,k}(x,y,z), \text{ mit} \tag{2}$$

$$H_{i,j,k}(x,y,z) = a_{i,j,k} x^i y^j z^k. \text{ Dabei ist} \tag{3}$$

$$m = i + j + k \tag{4}$$

die Ordnung der entsprechenden Komponente der Feldverteilung. Da die höheren Ordnungen mit zunehmendem Abstand vom Referenzpunkt rasch abklingen, reicht es, die niedrigeren Ordnungen im Ausgangssignal des Sensors zu unterdrücken. Die verbleibenden höheren Ordnungen enthalten dann in erster Linie die Information über den zu messenden Strom, während der Einfluß der weiter entfernten Quellen externer Felder stark vermindert ist. Dadurch wird - wie beabsichtigt- die Amplitude des Übersprechens reduziert.

Die Unterdrückung der niedrigen Ordnungen der Feldverteilung geschieht erfindungsgemäß dadurch, daß n-1 Beziehungen der Art

$$U^{out}_{i,j,k} = \sum_{l=1}^{n} b_l H_{i,j,k}(x_l, y_l, z_l) = 0 \tag{5}$$

für n-1 verschiedene Tripel von $(i,j,k)$ erfüllt werden. Diese Beziehungen sind äquivalent zu

$$\sum_{l=1}^{n} b_l x_l^i y_l^j z_l^k = 0 \tag{6}$$

Außerdem soll für das von einem Referenzstrom $I_o$ bei Abwesenheit von Störfeldern erzeugte Ausgangssignal gelten:

$$U^{out}_{I_o} = \sum_{l=1}^{n} b_l H_{I_o}(x_l, y_l, z_l) = 1 \tag{7}$$

Die n Feldamplituden

$$H_{l_{\mathrm{u}}}(x_l, y_l, z_l)$$

müssen dabei bekannt sein, d.h. sie müssen entweder rechnerisch oder experimentell ermittelt werden. Für nicht punktförmige, ausgedehnte Magnetfeldsensoren müssen die Größen $x_l^j y_l^j z_l^k$ und

$$H_{l_{\mathrm{u}}}(x_l, y_l, z_l)$$

durch die über das Sensorvolumen gemittelten Werte ersetzt werden.

Die Beziehungen (6) und (7) bilden dann zusammen ein System aus n linear unabhängigen Gleichungen mit den n unbekannten Koeffizienten $b_l$, das in diesen mit Hilfe bekannter Matrixmethoden eindeutig gelöst werden kann. Ein Sensorsystem mit diesen Einstellungen liefert dann ein zum Nutzstrom proportionales Ausgangssignal und unterdrückt die niedrigen Ordnungen (externer) Magnetfeldverteilungen. Es weist also deutlich reduzierte Übersprechamplituden auf. Die Anordnung der Sensoren kann im speziellen Fall dreidimensional, zweidimensional (in einer Ebene) oder eindimensional (auf einer Geraden) erfolgen. Die Lage des Koordinatensystems wird zweckmäßigerweise so gewählt, daß in den obigen Gleichungen nur die notwendige Zahl von Ortskoordinaten (3, 2, oder 1) auftritt. Um eine optimale Unterdrückung von Fremdfeldern zu erreichen, sollte das Sensorarray so ausgelegt sein, daß bis zu einer bestimmten Ordnung $m \geq 0$ alle Komponenten $H_{i,j,k}(x,y,z)$ mit $i + j + k \leq m$; und $i,j,k \ \varepsilon[0,m]$ kompensiert werden. In der folgenden Tabelle ist die dazu erforderliche Zahl von Sensoren in Abhängigkeit von der höchsten, vollständig unterdrückten Ordnung und der Dimensionalität des Arrays dargestellt.

| Dimensionalität des | Höchste, vollständig kompensierte Ordnung der Feldverteilung | | | |
|---|---|---|---|---|
| Sensor-Arrays | 0 | 1 | 2 | 3 |
| 1 | 2 | 3 | 4 | 5 |
| 2 | - | 4 | 7 | 11 |
| 3 | - | 5 | 11 | 21 |

Es ist ersichtlich, daß die Zahl (hier 2 bis 21) der erforderlichen Sensoren bei gegebener höchster, kompensierter Ordnung schnell mit der Dimensionalität der Anordnung ansteigt. Im allgemeinen ist es also angezeigt, die Dimensionalität niedrig zu halten (also z. B. eine lineare Anordnung zu verwenden), wenn dies aufgrund der Geometrie des Leiters oder der Umgebung des Stromsensors möglich ist. Andernfalls kann die Anordnung der Sensoren jedoch im Prinzip beliebig zwei- oder dreidimensional gestaltet und den äußeren Gegebenheiten (z. B. speziellen Gehäuseformen oder Leitergeometrien) angepaßt werden.

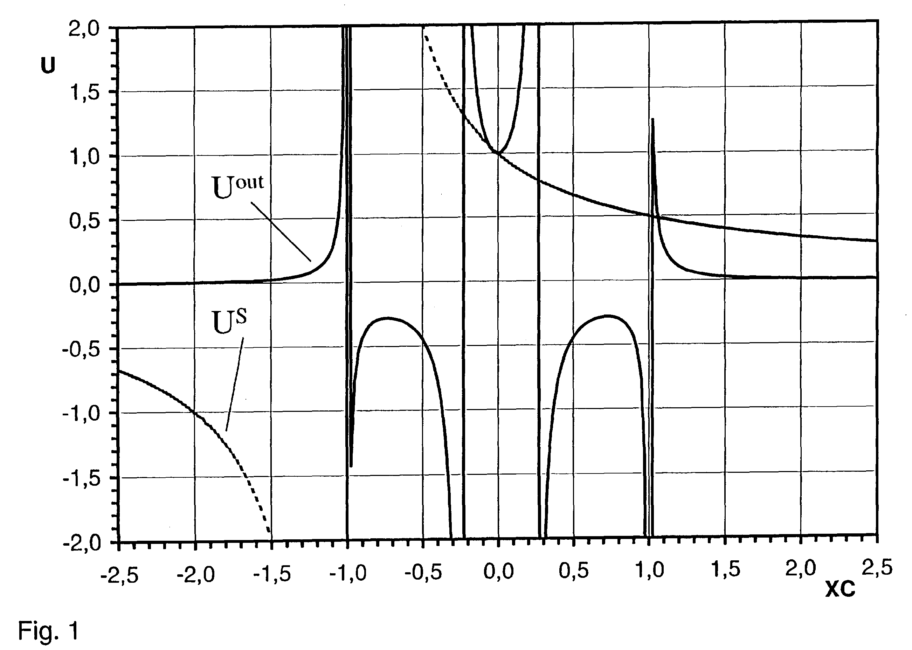

In Fig. 1 ist beispielhaft das normierte Ausgangssignal $U^{out}$ eines symmetrischen, linearen Arrays mit vier Sensoren in Abhängigkeit von der Lage des Schnittpunkts des als geradlinig angenommenen Stromleiters L mit der dazu senkrechten Verbindungsachse der Sensoren dargestellt (durchgezogene Kurve). Da der Durchmesser des Leiters hier zu Null gesetzt wurde, weist die Kurve Singularitäten an den Positionen der vier Sensoren auf. In der Normalposition des Leiters bei XC = 0 besitzt die Signalamplitude ein Minimum und ist daher unempfindlich gegen Verschiebungen. Außerhalb des Arrays befindliche Leiter (z. B. für $|XC| \geq 1{,}5$) können als Störquellen aufgefaßt werden. Wie der Vergleich mit dem Ausgangssignal $U^S$ eines einzelnen Sensorelements (gestrichelte Kurve) zeigt, fällt die Empfindlichkeit der erfindungsgemäßen Anordnung gegenüber solchen Störleitern mit zunehmendem Abstand sehr viel steiler ab, als die eines einzelnen Magnetfeldsensors: Bei einem Abstand von A = 2,5 Einheiten (bezogen auf die Position der äußeren Sensorelemente) beträgt das theoretische Übersprechen durch einen Strom gleicher Amplitude für die dargestellte Anordnung nur noch 0,19%.

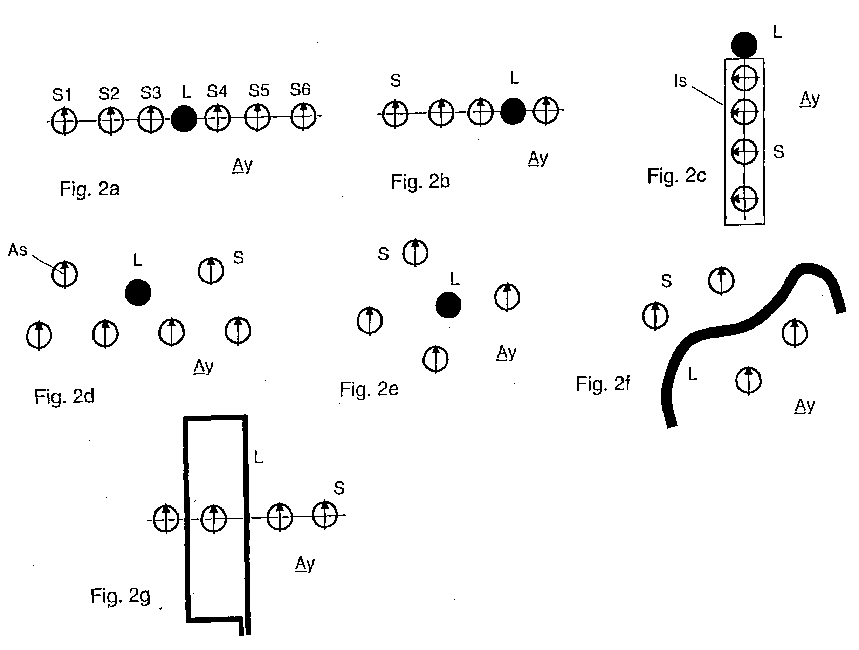

In den Fig. 2a bis 2f und 3 bis 6 sind als Ausgestaltungen der Erfindung spezielle topologische Alternativen, alternative Elementarsensoren Signalverknüpfungsmöglichkeiten und Anordnungen in Mehrphasensystemen angegeben.

1) Topologische Alternativen

In Fig. 2a bis 2f sind mögliche topologische Alternativen für die Strommessung mit Sensorarrays Ay dargestellt. Mit einer geraden Anzahl n von Sensoren S können symmetrische Anordnungen aufgebaut werden, wie Fig. 2a zeigt. Diese haben den Vorteil, daß das Ausgangssignal unempfindlich gegen Verschiebungen des Stromleiters L um seine Ruhelage ist. Außerdem werden durch eine solche Anordnung zusätzlich auch alle geradzahligen höheren Ordnungen der Störlelder (bezogen auf X=0) kompensiert.
Eindimensionale asymmetrische Geometrien können für bestimmte Anwendungen vorteilhaft sein. Solche Beispiele zeigen die Figuren 2b und 2c. Zum Beispiel können asymmetrische Arrays in Stützisolatoren Is von Mittel- oder Hochspannungsanlagen eingebaut werden. Weitere Möglichkeiten für zwei- oder dreidimensionale Anordnungen sind aus den Figuren 2d und 2e ersichtlich (eine dreidimensionale Anordnung mit unterschiedlichem Abstand der Sensorelemente von der Zeichenebene ist durch Darstellung in unterschiedlichen Graustufen angedeutet; siehe Fig. 2e und 2f). Diese können aus Platzgründen vorteilhaft sein. Das Prinzip ist nicht auf geradlinige Leiteranordnungen begrenzt. In Fig. 2f ist eine Anordnung eines nichtgeradlinigen Leiters L und mehrerer Sensoren S dargestellt. Fig. 2g zeigt, wie dabei z.B. durch Verwendung einer Leiterschleife das Verhältnis von Nutz- zu Störsignal weiter vergrößert werden kann. Die Einstellung der Parameter $b_I$ muß jeweils in Abhängigkeit von der speziellen Geometrie erfolgen, die stabil zu halten ist. Vorteilhafterweise werden Array Ay und Stromleiter L fest miteinander verbunden. Bei linearen oder zweidimensionalen Arrays können die Sensoren günstig auf einem ebenen, gemeinsamen Substrat (z. B. einer Leiterplatte) montiert werden. In allen Fällen verlaufen jedoch die sensitiven Achsen $A_S$ der Sensoren S parallel zueinander. In den Fig. 2a bis 2d wird von einem geradlinigen Leiter mit einem Verlauf senkrecht zur Zeichenebene ausgegangen.

2) Stromformen und alternative Elementarsensoren

Die erfindungsgemäßen Sensorarrays können alternativ mit gleichfeldfähigen Sensoren, die ein dem Momentanwert des Magnetfeldes proportionales Ausgangssignal liefern, oder mit ausschließlich wechselfeldsensitiven Elementen, deren Ausgangssignal der Feldänderung proportional ist, ausgestattet werden. Um ein stromproportionales Signal des Systems zu erhalten, können im letzteren Fall entweder die Einzelsignale der Elemente getrennt zeitintegriert werden, oder aber es erfolgt eine Integration des Gesamtsignals am Ausgang des Stromsensors.
Als Magnetfeldsensoren sind nach geeigneten Maßnahmen zur Linearisierung der Elemente insbesondere einsetzbar:

- passive Luft- oder Eisenspulen (für reine Wechselstromanwendungen)
- getaktete Induktivitäten, auf dem Halleffekt basierende Elemente (z. B. auch MagFETs), magnetoresistive Sensoren (der Typen AMR, GMR, CMR) und magnetooptische Sensoren (für beliebige Stromformen).

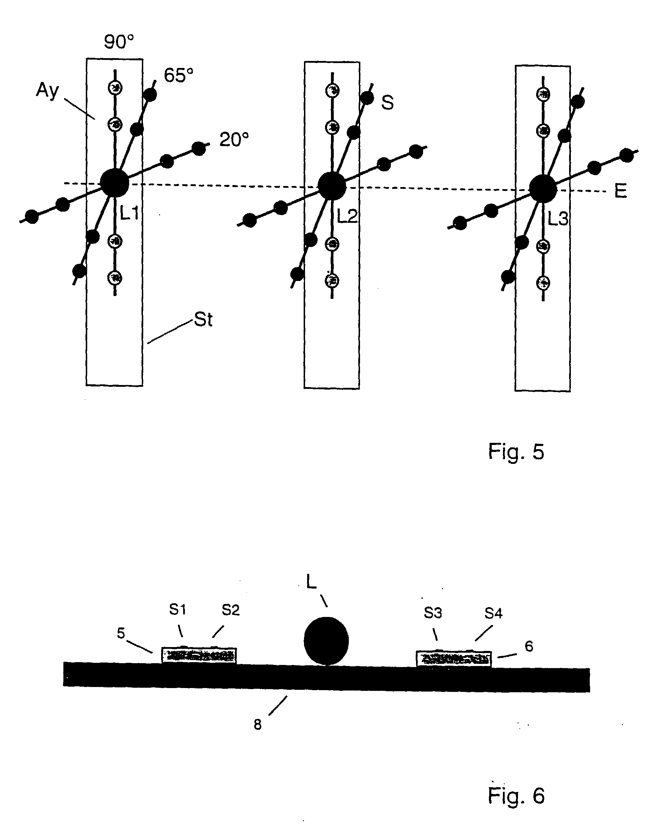

In speziellen Fällen, hier in Fig. 6 dargestellt, kann die Integration von Sensorelementen S1 bis S4 auf einem oder mehreren Halbleiterchips 5, 6 vorteilhaft sein, beispielsweise in Paaren wie bei Differentialsensoren. Die Chips 5, 6 sind zusammen mit dem Leiter L auf einem gemeinsamen Substrat (Leiterplatte) 8 montiert.

3) Alternative Verknüpfung der Sensorsignale

Die Verknüpfung der einzelnen Sensorsignale gemäß Gleichung (1) (Gewichtung mit unterschiedlichen Faktoren und Summation) kann auf unterschiedliche Weise erfolgen:

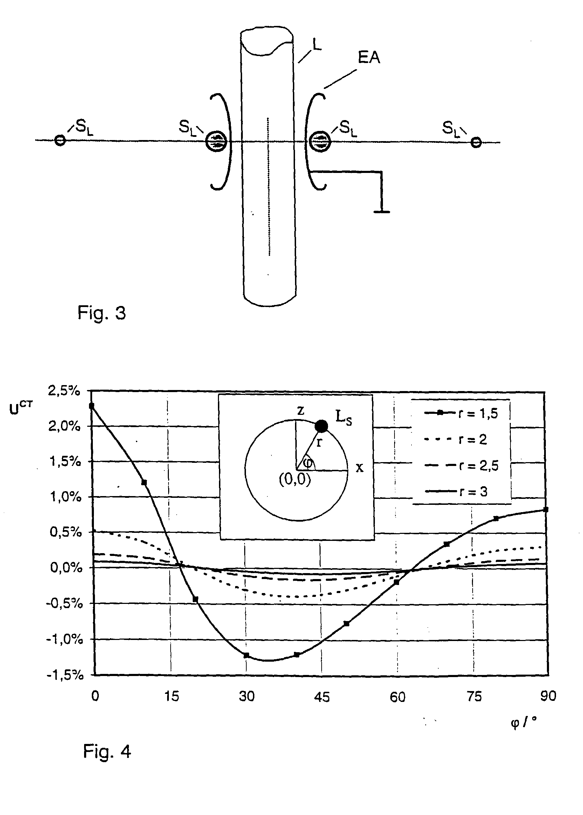

- in einer der bekannten analogen (Operations-) Verstärker-Addierschaltungen;
- durch individuell unterschiedliche Einzelverstärkung oder Abschwächung mit Spannungsteilern, und nachfolgende Summation;
- durch Summation der Ausgangssignale von Sensoren unterschiedlicher Empfindlichkeit, zum Beispiel von Spulen mit unterschiedlichem Querschnitt (vergl. Fig. 3), oder unterschiedlicher Windungszahl;
- bei Sensoren mit potentialfreiem Ausgang, z. B. bei passiven Spulen, oder Sensoren mit isolierter Versorgungsspannung, besteht die Möglichkeit der Summation der Ausgangsspannungen durch direkte Serienschaltung;
- bei Sensoren mit Stromausgang besteht die Möglichkeit der Summation durch direkte Verbindung der einzelnen Ausgänge (Parallelschaltung);
- durch Digitalisierung der Einzelsignale und anschließende digitale Multiplikation und Addition. Bei induktiven Sensoren kann auch die erforderliche Integration digital erfolgen.

Fig. 3 zeigt eine Anordnung mit einem Leiter L und vier Luftspulen $S_L$ als Sensoren, die ein symmetrisches, eindimensionales Array bilden. Die Luftspulen $S_L$ haben unterschiedliche Querschnitte. Zwischen den Leiter L und die Luftspulen $S_L$ ist eine elektrostatische Abschirmung EA eingefügt.

4) Spezielle Anordnungen in Mehrphasen-Systemen

Sensorarrays für die Strommessung weisen im allgemeinen eine Richtungsabhängigkeit ihres Übersprechverhaltens auf. Fig. 4 zeigt für den Fall eines symmetrischen, linearen Arrays mit vier Sensoren die Abhängigkeit der Übersprechamplitude $U^{CT}$ (Kurvenzüge) von der Winkelposition bei Rotation eines Störleiters $L_S$ um den Mittelpunkt des Arrays für verschiedene Abstände r. Bei der Strommessung in Mehrphasensystemen kann hieraus ein Vorteil gezogen werden, indem die Arrays in ihrer Winkelposition so ausgerichtet werden, daß das Übersprechen durch die in bekannter Position befindlichen Nachbarleiter minimiert wird. In Fig. 5 sind drei Leiter L1, L2, L3 eines Dreileitersystems dargestellt, sowie jeweils lineare Sensor-Arrays mit vier Sensoren S, die bezogen auf die Leiterebene E in den drei (alternativen) Winkelpositionen 20°, 65° und 90° angeordnet sind. In dem gewählten Beispiel ergibt sich minimales Übersprechen in der Nähe der Winkellagen 20° und 65°. Besser an die Geometrie von Stützisolatoren St angepaßt ist eine Orientierung von 90° (der ebenfalls eine noch annehmbare Übersprechamplitude entspricht). Nicht empfehlenswert ist in diesem Fall die Anordnung der Sensoren in der Leiterebene E.

**Patentansprüche**

1. Verfahren zur Ermittlung des in einem elektrischen Leiter (L) fließenden Stromes durch Bildung eines dem Strom proportionalen Ausgangssignals ($U^{out}$) eines Sensor-Arrays (Ay), wobei

   a) das Sensor-Array (Ay) durch eine Anzahl n von linearen uniaxialen Magnetfeldsensorelementen (S1....Sn) gebildet wird, die an wählbaren festen Positionen ($x_l$, $y_l$, $z_l$) in der Nähe des Leiters (L) angeordnet werden,
   b) die sensitiven Achsen ($A_S$) der Sensorelemente (S1....Sn) parallel zueinander ausgerichtet werden und
   c) die feldstärkeabhängigen elektrischen Ausgangssignale $H(x_l, y_l, z_l)$ der Sensorelemente (S1...Sn) entsprechend nachstehender Gleichung verknüpft werden:

$$U^{out} = \sum_{l=1}^{n} b_l H(x_l, y_l, z_l)$$

   mit

   $U^{out} =$      durch Summierung entstehendes Ausgangssignal des Sensor-Arrays (Ay),
   $b_l =$      individuelle Koeffizienten, mit denen die Ausgangssignale multipliziert werden,
   $H(x_l, y_l, z_l) =$      feldstärkeproportionale Ausgangssignale der Sensorelemente, die sich an den Positionen $x_l$, $y_l$, $z_l$ befinden,
   $l =$      Laufindex der 1...n Sensorelemente S,

   wobei die individuellen Koeffizienten $b_l$ so bestimmt werden, daß die n nachstehenden Gleichungen erfüllt sind:

$$\sum_{l=1}^{n} b_l x_l^{i} y_l^{j} z_l^{k} = 0 \text{ (für n-1 verschiedene Trippel (i, j, k)) und}$$

$$U^{out}_{l_o} = \sum_{l=1}^{n} b_l H_{l_o}(x_l, y_l, z_l), = 1$$

   mit

   $U^{out}_{l_o} =$      beim Referenzstrom $I_o$ und bei Abwesenheit von Störfeldern erzeugtes Ausgangssignal,

und wobei die unter diesen Bedingungen auftretenden n Feldamplituden

$$H_{I_0}\left(x_1, y_1, z_1\right)$$

rechnerisch oder experimentell ermittelt werden.

2. Verfahren nach Anspruch 1, dadurch gekennzeichnet, daß als Sensorarray (Ay) eine lineare. symmetrische Anordnung einer geradzahligen Anzahl n von Sensoren (S1...Sn) um einen geradlinigen Leiter (L) verwendet wird.

3. Verfahren nach Anspruch 1, dadurch gekennzeichnet, daß als Sensorarray (Ay) eine ein- oder mehrdimensionale asymmetrische Anordnung von Sensoren (S1...Sn) um einen geradlinigen oder nichtgeradlinigen Leiter (L) verwendet wird.

4. Verfahren nach einem der vorstehenden Ansprüche, dadurch gekennzeichnet, daß Magnetfeldsensoren (S1....Sn) verwendet werden, die ausgewählt sind aus passiven Luft- oder Eisenspulen, getakteten Induktivitäten, auf dem Halleffekt basierenden Elementen, magnetoresistiven Sensoren und magnetooptischen Sensoren.

5. Verfahren nach einem der Ansprüche 1 bis 3, dadurch gekennzeichnet, daß zur Durchführung eine Anordnung verwendet wird, bei der auf einem Substrat (8) ein Leiter (L) und mindestens ein Halbleiterchip (5,6) mit Sensorelementen (S1....Sn) angeordnet sind.

6. Verfahren nach einem der vorstehenden Ansprüche, dadurch gekennzeichnet, daß gleichfeldfähige oder ausschließlich wechselfeldsensitive Sensoren (S1....Sn) verwendet werden, und daß ein stromproportionales Ausgangssignal ($U^{out}$) entweder durch getrennte Zeitintegration der Einzelsignale der Sensoren (S1....Sn) oder durch Integration des Gesamtsignals des Arrays (Ay) ermittelt wird.

7. Verfahren nach Anspruch 1, dadurch gekennzeichnet, daß die Anordnung und Koeffizienten so gewählt werden, daß Störfelder unterhalb einer bestimmten Ordnung vollständig unterdrückt werden.

8. Verfahren nach Anspruch 2, dadurch gekennzeichnet, daß in einem Mehrphasensystem eine Winkeleinstellung gegen die Leiterebene gewählt wird, die ein minimales Übersprechen durch die Nachbarphasen bewirkt.

9. Verfahren nach Anspruch 1, dadurch gekennzeichnet, daß eine lineare, asymmetrische Sensoranordnung mit einer Verbindungsachse senkrecht zur Leiterebene gewählt wird.

10. Verfahren nach einem der vorstehenden Ansprüche, dadurch gekennzeichnet, daß Sensoren unterschiedlicher Empfindlichkeit verwendet werden, oder daß ihre Ausgangssignale in einer analogen oder digitalen Auwerteschaltung mit unterschiedlichen Faktoren gewichtet werden.

11. Verfahren nach vorstehenden Ansprüchen, dadurch gekennzeichnet, daß die Verknüpfung der Sensorsignale entweder digital oder durch eine aktive Verstärker-Addierschaltung oder durch passive Serien- (bei Spannungssignalen) oder Parallelschaltung (bei Stromausgängen) vorgenommen wird.

Fig. 1

EP 0 947 843 A2

Fig. 2a

Fig. 2b

Fig. 2c

Fig. 2d

Fig. 2e

Fig. 2f

Fig. 2g

EP 0 947 843 A2

Fig. 3

Fig. 4

Fig. 5

Fig. 6